# EUROPÄISCHE PATENTSCHRIFT

(11) **EP 2 307 797 B1**
(45) Veröffentlichungstag und Bekanntmachung des Hinweises auf die Patenterteilung: **04.01.2012**
(21) Anmeldenummer: 09779752.6
(22) Anmeldetag: 15.06.2009
(51) Int. Cl.: F21V 14/08

(54) **STRAHLUNGSEMITTIERENDE VORRICHTUNG**
RADIATION-EMITTING APPARATUS
DISPOSITIF ÉMETTEUR DE RAYONNEMENT

(30) Priorität: 07.07.2008 DE 102008031996
(43) Veröffentlichungstag der Anmeldung: 13.04.2011
(73) Patentinhaber: Osram AG, 81543 München (DE)
(72) Erfinder: SCHALLMOSER, Oskar, 85521 Ottobrunn (DE)
(86) Internationale Anmeldenummer: PCT/EP2009/057373
(87) Internationale Veröffentlichungsnummer: WO 2010/003763

(56) Entgegenhaltungen:
- WO-A-00/19546
- WO-A-2005/055328
- WO-A-2009/021859

## Beschreibung

Die vorliegende Erfindung betrifft eine strahlungsemittierende Vorrichtung mit einem strahlungsemittierenden Bauelement nach dem Oberbegriff des Anspruchs 1.

Bei Beleuchtungseinrichtungen mit veränderbarer Farbe oder Farbtemperatur können verschiedenfarbige Einzellichtquellen zu einer Lampe kombiniert werden, wobei die Helligkeit der Einzellichtquellen zum Beispiel durch Stromänderung individuell eingestellt wird. Die resultierende Mischlichtfarbe der Lampe ist dadurch variabel. Dabei leuchten jedoch im Normalbetrieb nicht alle Einzellichtquellen gleichzeitig mit maximaler Helligkeit. Um eine gewünschte Lichtmenge, die von der Lampe abgestrahlt werden kann, zu erhalten, müssen also mehr Einzellichtquellen verwendet werden, als tatsächlich für die gewünschte Lichtmenge nötig sind. Weiterhin ist zur Einstellung der abgestrahlten Farbtemperatur eine aufwändige elektronische Regelung notwendig. Eine derartige Lampe ist daher aufwändig und kostenintensiv.

Weiterhin sind Beleuchtungseinrichtungen mit durchscheinenden Farbfilterfolien bekannt, durch die das Licht einer Lichtquelle hindurchgestrahlt wird und so seine Farbe ändert. Dadurch wird jedoch Licht weggefiltert und die durch die Lichtquelle maximal erreichbare Helligkeit herabgesetzt, wodurch bei derartigen Beleuchtungseinrichtungen der Wirkungsgrad sinkt und damit die Herstellungs- und Betriebskosten steigen.

Zumindest eine Aufgabe von bestimmten Ausführungsformen ist es, eine strahlungsemittierende Vorrichtung zur Abstrahlung einer veränderbaren elektromagnetischen Sekundärstrahlung anzugeben, die die oben angegebenen Nachteile vermeidet.

Diese Aufgabe wird durch einen Gegenstand mit den Merkmalen des unabhängigen Patentanspruchs 1 gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Eine strahlungsemittierende Vorrichtung zur Abstrahlung einer veränderbaren elektromagnetischen Sekundärstrahlung in einer Abstrahlrichtung umfasst gemäß einer Ausführungsform insbesondere
- zumindest ein strahlungsemittierendes Bauelement, das im Betrieb eine elektromagnetische Primärstrahlung emittiert,
- einen Reflektor, der im Strahlengang des strahlungsemittierenden Bauelements angeordnet ist und der einen ersten Wellenlängenkonversionsstoff zur zumindest teilweisen Konversion der Primärstrahlung in eine elektromagnetische Konversionsstrahlung aufweist, und
- eine Blende, die in ihrer Ausrichtung relativ zum strahlungsemittierenden Bauelement und zum Reflektor veränderbar ist,
   wobei
- mittels Veränderung der Ausrichtung der Blende die Sekundärstrahlung veränderbar ist durch Veränderung des Anteils der Primärstrahlung, der vom strahlungsemittierenden Bauelement auf den ersten Wellenlängenkonversionsstoff abgestrahlt wird, und durch Veränderung der abgestrahlten Konversionsstrahlung.

Hier und im Folgenden bezeichnet "elektromagnetische Strahlung" im Allgemeinen und "elektromagnetische Primärstrahlung", "elektromagnetische Sekundärstrahlung" und "elektromagnetische Konversionsstrahlung" im Besonderen jeweils elektromagnetische Strahlung beziehungsweise Licht mit Wellenlängen aus einem ultravioletten bis infraroten Wellenlängenbereich. Die Konversionsstrahlung und die Primärstrahlung sind dabei verschieden voneinander. Das kann insbesondere bedeuten, dass die Primärstrahlung eine erste spektrale Verteilung von spektralen Komponenten, also einzelnen Wellenlängen oder Wellenlängenbereichen mit zugehörigen Intensitäten, und die Konversionsstrahlung eine zweite spektrale Verteilung aufweist, wobei die erste und zweite spektrale Verteilung in zumindest einer Wellenlänge verschieden voneinander sind. Insbesondere die Sekundärstrahlung und die Konversionsstrahlung, und weiterhin auch die Primärstrahlung, können dabei Wellenlängen aus einem sichtbaren Wellenlängenbereich aufweisen und damit sichtbares Licht sein. Besonders bevorzugt können solche Wellenlängen und Wellenlängenbereiche emittiert werden, die einen einfarbigen, mischfarbigen oder einen weißen, insbesondere einen kaltweißen oder einen warmweißen, Leuchteindruck bei einem Betrachter erwecken können. Ein von einem externen Beobachter wahrnehmbarer Leuchteindruck einer elektromagnetischen Strahlung kann beispielsweise durch den Farbort in der dem Fachmann bekannten CIE-1931-Normfarbtafel charakterisierbar sein. Ein weißer Leuchteindruck kann weiterhin durch die dem Fachmann bekannte Farbtemperatur und korrelierte Farbtemperatur charakterisiert werden.

Hier und im Folgenden kann eine "Änderung" einer elektromagnetischen Strahlung oder eines Anteils einer elektromagnetischen Strahlung insbesondere eine Änderung der Intensität, der Farbe, der Farbtemperatur oder einer Kombination daraus bedeuten. Insbesondere kann bezüglich der Primärstrahlung eine Änderung des Anteils der Primärstrahlung, der vom strahlungsemittierenden Bauelement auf den ersten Wellenlängenkonversionsstoff abgestrahlt wird, eine Änderung der Gesamtstrahlungsleistung der auf den ersten Wellenlängenkonversionsstoff abgestrahlten Primärstrahlung bedeuten. Eine Änderung der Konversionsstrahlung kann hier und im Folgenden insbesondere eine Änderung der Strahlungsleistung der von der strahlungsemittierenden Vorrichtung abgestrahlten Konversionsstrahlung und/oder eine Änderung der spektralen Zusammensetzung der Konversionsstrahlung bedeuten.

Hier und im Folgenden bezeichnet "Reflektor" ein optisches Bauelement, das, wenn elektromagnetische Strahlung eingestrahlt wird, wiederum elektromagnetische Strahlung abstrahlt, die gleich oder verschieden zur eingestrahlten elektromagnetischen Strahlung sein kann. In der hier beschriebenen strahlungsemittierenden Vorrichtung wird insbesondere Primärstrahlung auf den Reflektor eingestrahlt und Konversionsstrahlung oder Konversionsstrahlung zusammen mit teilweiser unkonvertierter Primärstrahlung wiederum vom Reflektor abgestrahlt.

Hier und im Folgenden bezeichnet "Blende" ein optisches Bauelement, das geeignet ist, elektromagnetische Strahlung aus einem Raumwinkelbereich auszublenden und damit diesen Raumwinkelbereich abzuschatten. Durch die veränderbare Ausrichtung der Blende ist auch der abschattbare Raumwinkelbereich veränderbar. Insbesondere ist eine Blende im hier verwendeten Sinne für elektromagnetische Strahlung nicht transparent und weiterhin auch nicht transluzent.

Dass die Blende relativ zum strahlungsemittierenden Bauelement und zum Reflektor veränderbar kann insbesondere beinhalten, dass die das strahlungsemittierende Bauelement und der Reflektor starr gelagert sind. Das kann bedeuten, dass die strahlungsemittierende Vorrichtung ein Gehäuse und/oder ein Bauteil zur dauerhaften Montage und/oder wieder lösbaren Befestigung der strahlungsemittierenden Vorrichtung aufweist und das strahlungsemittierende Bauelement und der Reflektor im oder am Gehäuse und/oder an dem Bauteil zur Montage und/oder Befestigung fest und unbewegbar angebracht sind. Die Blende hingegen ist in ihrer Ausrichtung relativ zu dem Gehäuse und/oder dem Bauteil zur Montage und/oder Befestigung veränderbar.

Die hier beschriebene strahlungsemittierende Vorrichtung kann die Einstellung und Anpassung der abgestrahlten Sekundärstrahlung, beispielsweise deren Intensität, Farbtemperatur und/oder Farbort, durch eine relative Änderung der Ausrichtung der Blende relativ zum strahlungsemittierenden Bauelement und zum Reflektor ermöglichen. Dabei kann es möglich sein, dass das strahlungsemittierende Bauelement während des elektronischen Betriebs der strahlungsemittierenden Vorrichtung durchgehend und dauerhaft in einem unveränderten Betriebszustand betrieben werden kann. Dadurch kann das strahlungsemittierende Bauelement während des Betriebs eine unveränderte Primärstrahlung abstrahlen, während die von der strahlungsemittierenden Vorrichtung abgestrahlte Sekundärstrahlung dennoch veränderbar ist. Ein unveränderter Betriebszustand des strahlungsemittierenden Bauelements kann dabei bedeuten, dass die Primärstrahlung unverändert hinsichtlich ihrer Intensität und ihres Spektralbereichs beibehalten wird. Das strahlungsemittierende Bauelement muss also beispielsweise nicht gedimmt werden. Dadurch kann es möglich sein, dass eine wie oben beschriebene aufwändige Regelung der elektrischen Versorgung des strahlungsemittierenden Bauelements zur Regelung der Sekundärstrahlung verringert werden oder ganz entfallen kann. Es ist damit möglich, dass die Änderbarkeit der Sekundärstrahlung keinen Einfluss auf den Betriebszustand des strahlungsemittierenden Bauelements hat, also beispielsweise auf die Temperatur oder elektrische Parameter wie etwa die angelegte Spannung oder den aufgeprägten Strom.

Die Sekundärstrahlung kann die Primärstrahlung und/oder die Konversionsstrahlung umfassen und kann dabei derart veränderbar sein, dass zumindest einer der Parameter Intensität, Farbe, also Farbort, und Farbtemperatur der Sekundärstrahlung veränderbar ist. Die Sekundärstrahlung kann dabei insbesondere in Abhängigkeit von der Ausrichtung der Blende relativ zum strahlungsemittierenden Bauelement und zum Reflektor einen durch die Blendenausrichtung veränderbaren Anteil der Primärstrahlung und/oder der Konversionsstrahlung aufweisen. Der veränderbare Anteil der Primärstrahlung und/oder der veränderbare Anteil der Konversionsstrahlung an der Sekundärstrahlung können jeweils zwischen einem maximalen Wert und einem minimalen Wert veränderbar sein. Der maximale und der minimale Wert des veränderbaren Anteils der Primärstrahlung können dabei bei zwei bestimmten, voneinander verschiedenen Ausrichtungen der Blende hervorgerufen werden. Ebenso können der maximale und der minimale Wert des Anteils der Konversionsstrahlung, der durch den ersten Wellenlängenkonversionsstoff abgestrahlt wird, bei zwei bestimmten Ausrichtungen der Blende hervorgerufen werden. Der minimale Wert kann für die Primärstrahlung und/oder für die Konversionsstrahlung eine endliche, von Null verschiedene Strahlungsleistung bedeuten oder auch eine Strahlungsleistung von Null. Das kann bedeuten, dass die Sekundärstrahlung in einer bestimmten Ausrichtung der Blende nur Konversionsstrahlung und keine Primärstrahlung und/oder in einer bestimmten anderen Ausrichtung der Blende nur Primärstrahlung und keine Konversionsstrahlung aufweist. Durch eine kontinuierliche Änderung der Ausrichtung der Blende zwischen den zwei bestimmten Ausrichtungen der Blende kann eine kontinuierliche Veränderung der Sekundärstrahlung durch eine Veränderung des Anteils der Primärstrahlung und/oder der Konversionsstrahlung erreicht werden.

Weiterhin kann die Sekundärstrahlung in Abhängigkeit von der Ausrichtung der Blende relativ zum strahlungsemittierenden Bauelement und zum Reflektor eine durch die Blendenausrichtung veränderbare spektrale Zusammensetzung der Konversionsstrahlung aufweisen. Die spektrale Zusammensetzung der Konversionsstrahlung, also die Gesamtheit der spektralen Komponenten der Konversionsstrahlung, kann durch Veränderung der Ausrichtung der Blende zwischen einem ersten Spektrum und einem zweiten Spektrum veränderbar sein, wobei das erste Spektrum und das zweite Spektrum durch jeweils eine bestimmte Ausrichtung der Blende hervorgerufen werden können.

Beispielsweise kann der Reflektor einen ersten Teilbereich mit dem ersten Wellenlängenkonversionsstoff und einen zweiten Teilbereich mit einem zweiten Wellenlängenkonversionsstoff zur Konversion der Primärstrahlung in elektromagnetische Konversionsstrahlung aufweisen, wobei der zweite Wellenlängenkonversionsstoff verschieden vom ersten Wellenlängenkonversionsstoff ist. Der erste und der zweite Teilbereich können dabei direkt benachbart aneinander angrenzen. Die Konversionsstrahlung, die vom ersten Wellenlängenkonversionsstoff abgestrahlt wird, kann somit verschieden von der Konversionsstrahlung sein, die vom zweiten Wellenlängenkonversionsstoff abgestrahlt wird. Durch Veränderung der Ausrichtung der Blende relativ zum Reflektor kann das Verhältnis des Anteils der Primärstrahlung, der auf den ersten Wellenlängenkonversionsstoff eingestrahlt wird, und des Anteils der Primärstrahlung, der auf den zweiten Wellenlängenkonversionsstoff eingestrahlt wird, veränderbar sein. Dadurch können der vom ersten Teilbereich abgestrahlte Anteil und der vom zweiten Teilbereich abgestrahlte Anteil der Konversionsstrahlung an der Sekundärstrahlung relativ zueinander veränderbar sein, so dass die Konversionsstrahlung und damit auch die Sekundärstrahlung hinsichtlich ihrer spektralen Zusammensetzung veränderbar sein können.

Weiterhin kann der Reflektor eine Mehrzahl der ersten Teilbereiche mit dem ersten Wellenlängenkonversionsstoff und eine Mehrzahl der zweiten Teilbereiche mit dem zweiten Wellenlängenkonversionsstoff aufweisen. Die ersten und zweiten Teilbereiche können dabei abwechselnd nebeneinander angeordnet sein. Die ersten und zweiten Teilbereiche können dabei linear, also entlang einer Geraden oder eines Bogens, angeordnet sein oder entlang zweier Richtungen, also beispielsweise schachbrett- oder matrixartig. Weiterhin kann die Anordnung der ersten und zweiten Teilbereiche kreis- oder ellipsenförmig in Form von Segmenten, Sektoren, Scheiben oder einer Kombination daraus sein.

Der Reflektor kann weiterhin teilweise reflektierend für die Primärstrahlung sein. Das kann bedeuten, dass ein Teil der Primärstrahlung, ohne durch den ersten und/oder den zweiten Wellenlängenkonversionsstoff konvertiert zu werden, vom Reflektor in Abstrahlrichtung der strahlungsemittierenden Vorrichtung umgelenkt wird. Dadurch kann die vom Reflektor abgestrahlte elektromagnetische Strahlung einen mischfarbigen Leuchteindruck aus einer Überlagerung der Konversionsstrahlung und der reflektierten Primärstrahlung erwecken. Der Reflektor kann dazu beispielsweise eine reflektierende Oberfläche aufwiesen, auf der der erste beziehungsweise gegebenenfalls der zweite Wellenlängenkonversionsstoff aufgebracht sind. Durch die reflektierende Oberfläche kann unkonvertierte Primärstrahlung, die den ersten Wellenlängenkonversionsstoff oder gegebenenfalls den zweiten Wellenlängenkonversionsstoff unkonvertiert durchquert hat, in den ersten beziehungsweise zweiten Wellenlängenkonversionsstoff zurückreflektiert werden, so dass die Konversionswahrscheinlichkeit dadurch effektiv erhöht werden kann.

Beispielsweise kann der Reflektor beziehungsweise seine reflektierende Oberfläche gerichtet oder diffus reflektierend sein. Eine gerichtete Reflektion kann etwa durch eine spiegelnde Oberfläche des Reflektors hervorgerufen werden. "Diffus reflektierend" kann insbesondere bedeuten, dass die Primärstrahlung, die gerichtet auf den Reflektor eingestrahlt werden kann, nicht abbildend und beispielsweise isotrop, also gleichmäßig in verschiedene Richtungen, vom Reflektor reflektiert werden kann. Dazu kann die reflektierende Oberfläche beispielsweise aufgeraut sein oder eine reflektierende Mikrostruktur aufweisen.

Alternativ dazu kann der Reflektor derart ausgebildet sein, dass nur Konversionsstrahlung in Abstrahlrichtung gelenkt und abgestrahlt wird. Dazu können der erste Wellenlängenkonversionsstoff und/oder gegebenenfalls der zweite Wellenlängenkonversionsstoff derart ausgebildet sein, dass die gesamte Primärstrahlung, die auf den Reflektor eingestrahlt wird, in Konversionsstrahlung umgewandelt wird. Alternativ oder zusätzlich kann der Reflektor eine Oberfläche aufweisen, auf der der erste und/oder - soweit vorhanden - der zweite Wellenlängenkonversionsstoff aufgebracht sind und die für die Primärstrahlung absorbierend ist. Derartige Ausgestaltungen können insbesondere dann vorteilhaft sein, wenn die Primärstrahlung ultraviolette Strahlung oder infrarote Strahlung umfasst oder ultraviolette oder infrarote Strahlung ist. Derartige Strahlung ist für einen externen Beobachter nicht wahrnehmbar und kann im Falle von ultravioletter Strahlung beispielsweise aus gesundheitlichen Gründen sogar unerwünscht sein.

Der Reflektor kann einen Kunststoff, ein Metall, eine Keramik oder Kombinationen daraus aufweisen oder aus einem der genannten Materialien sein. Beispielsweise kann der Reflektor aus Metall wie etwa Aluminium oder Silber sein oder zumindest eine Oberfläche aus einem Metall aufweisen. Weiterhin kann der Reflektor einen Kunststoff, besonders bevorzugt einen weißfarbigen Kunststoff, aufweisen.

Weiterhin kann der Reflektor Streupartikel aufweisen. Die Streupartikel können dabei auf der Oberfläche des Reflektors angeordnet sein oder sie können zusammen mit dem Wellenlängenkonversionsstoff wie oben beschrieben in einem Matrixmaterial eingeschlossen und auf dem Reflektor aufgebracht sein. Insbesondere können die Streupartikel beispielsweise ein Metalloxid, so etwa Titanoxid oder Aluminiumoxid wie etwa Korund, und/oder Glaspartikel umfassen. Die Streupartikel können dabei Durchmesser oder Korngrößen von weniger als einem Mikrometer bis zu einer Größenordnung von 10 Mikrometer aufweisen.

Der Wellenlängenkonversionsstoff, also der erste Wellenlängenkonversionsstoff und/oder - soweit vorhanden - der zweite Wellenlängenkonversionsstoff, kann einen oder mehrere der folgenden Materialien aufweisen: Granate der Seltenen Erden und der Erdalkalimetalle, beispielsweise YAG:Ce³⁺, Nitride, Nitridosilikate, Sione, Sialone, Aluminate, Oxide, Halophosphate, Orthosilikate, Sulfide, Vanadate, Perylene, Coumarin und Chlorosilikate. Weiterhin kann der Wellenlängenkonversionsstoff auch geeignete Mischungen und/oder Kombinationen daraus umfassen.

Weiterhin kann der Wellenlängenkonversionsstoff in einem transparenten Matrixmaterial eingebettet sein, das den Wellenlängenkonversionsstoff umgibt oder enthält oder das an den Wellenlängenkonversionsstoff chemisch gebunden ist. Das transparente Matrixmaterial kann beispielsweise Silikone, Epoxide, Acrylate, Imide, Carbonate, Olefine oder Derivate davon in Form von Monomeren, Oligomeren oder Polymeren als Mischungen, Copolymere oder Verbindungen damit aufweisen. Beispielsweise kann das Matrixmaterial ein Epoxidharz, Polymethylmethacrylat (PMMA) oder ein Silikonharz sein.

Der Wellenlängenkonversionsstoff kann dabei homogen im Matrixmaterial verteilt sein. Alternativ können verschiedene der oben genannten Materialien in verschiedenen Schichten oder Bereichen des Matrixmaterials verteilt und angeordnet sein.

Der Wellenlängenkonversionsstoff kann dabei direkt auf dem Reflektor aufgebracht sein. Der Wellenlängenkonversionsstoff und/oder das Matrixmaterial können beispielsweise durch ein Sprüh- oder Druckverfahren, mittels Dip-Coating, Rakeln, Aufpinseln oder mittels eines elektrophoretischen Verfahrens auf dem Reflektor aufbringbar sein.

Der Wellenlängenkonversionsstoff kann geeignet sein, die Primärstrahlung in Konversionsstrahlung mit einer größeren Wellenlänge umzuwandeln. so kann die Primärstrahlung beispielsweise spektrale Komponenten im ultravioletten bis grünen Wellenlängenbereich umfassen, die in Konversionsstrahlung mit spektralen Komponenten im gelben bis roten Wellenlängenbereich umgewandelt werden. Alternativ oder zusätzlich kann der Wellenlängenkonversionsstoff auch frequenzmischende und/oder frequenzverdoppelnde Eigenschaften aufweisen, so dass beispielsweise infrarote Primärstrahlung in sichtbare Konversionsstrahlung umgewandelt werden kann.

Weiterhin kann auch die Blende zumindest teilweise reflektierend ausgebildet sein. Dabei kann die Blende eines oder mehrere Merkmale aufweisen, die weiter oben im Zusammenhang mit dem Reflektor beschrieben sind. Je nach der weiter unten beschriebenen räumlichen Anordnung der Blende im Verhältnis zum strahlungsemittierenden Bauelement und zum Reflektor kann die Blende somit geeignet sein, den Anteil der Primärstrahlung, der auf die Blende eingestrahlt wird, in Abstrahlrichtung oder in Richtung des Reflektors zu lenken.

Dadurch, dass die Ausrichtung der Blende relativ zum strahlungsemittierenden Bauelement und zum Reflektor veränderbar ist, kann auch der Anteil der Primärstrahlung, der durch die zumindest teilweise reflektierende Blende reflektiert werden kann, verändert werden. Je nach der räumlichen Anordnung der Blende im Verhältnis zum strahlungsemittierenden Bauelement und zum Reflektor kann somit der Anteil der Primärstrahlung an der Sekundärstrahlung oder der Anteil der Primärstrahlung, der auf den Reflektor gelenkt beziehungsweise eingestrahlt wird, verändert werden, wodurch wiederum der Anteil an Konversionsstrahlung an der Sekundärstrahlung verändert werden kann.

Weiterhin kann die Blende einen dritten Wellenlängenkonversionsstoff zur zumindest teilweisen Konvertierung der Primärstrahlung in Konversionsstrahlung aufweisen, der verschieden vom ersten und - soweit vorhanden - verschieden vom zweiten Wellenlängenkonversionsstoff ist. Der dritte Wellenlängenkonversionsstoff kann dabei eines oder mehrere Merkmale aufweisen, die weiter oben im Zusammenhang mit dem ersten und zweiten Wellenlängenkonversionsstoff beschrieben sind. Damit kann die Sekundärstrahlung neben der Primärstrahlung und/oder der Konversionsstrahlung, die vom Reflektor abgestrahlt wird, auch Konversionsstrahlung aufweisen, die von der Blende abgestrahlt wird.

Dadurch, dass die Ausrichtung der Blende relativ zum strahlungsemittierenden Bauelement und zum Reflektor veränderbar ist, kann auch der Anteil der Primärstrahlung, der auf die Blende eingestrahlt wird, verändert werden. Dadurch kann der Anteil der Primärstrahlung, der durch den dritten Wellenlängenkonversionsstoff in Konversionsstrahlung umgewandelt werden kann, und damit der Anteil der Konversionsstrahlung an der Sekundärstrahlung verändert werden.

Die Blende kann eine Form aufweisen, die an die Form des Reflektors angepasst ist. Das kann bedeuten, dass der Reflektor beispielsweise eine polygonale oder runde Form oder eine Kombination daraus aufweisen kann. Die Blende kann dazu eine Form aufweisen, die geeignet ist, zumindest einen Teil oder auch den gesamten Reflektor in zumindest einer Ausrichtung der Blende relativ zum Reflektor abzuschatten. Das kann insbesondere bedeuten, dass die Blende eine ähnliche oder dieselbe Form wie der Reflektor aufweist. Beispielsweise können der Reflektor und die Blende jeweils eine rechteckige, elliptische oder kreisförmige Fläche aufweisen, die übereinander in Deckung gebracht werden können. Geometrische Flächenangeben den Reflektor und die Blende betreffend können sich auf eine Euklidische oder nicht-Euklidische Geometrie beziehen. Das kann bedeuten, dass die Flächenbegrenzung des Reflektor und/oder der Blende eine polygonale und/oder runde Form aufweist und die davon begrenzte Fläche im Falle einer Euklidischen Geometrie eben oder im Falle einer nicht-Euklidischen Geometrie gekrümmt ist. Beispielsweise können der Reflektor und/oder die Blende als Teil eines Zylindermantels, als Teil einer Kugelschale, eines Rotationsellipsoiden, Rotationsparaboloiden oder Rotationshyperboloiden oder einer Kombination daraus ausgebildet sein.

Die Blende kann insbesondere derart ausgebildet und in zumindest einer Ausrichtung derart relativ zum strahlungsemittierenden Bauelement und zum Reflektor angeordnet sein, dass die Blende von einem externen Beobachter aus gesehen zumindest einen Teil des Reflektors abdeckt. Der Teil des Reflektors, der durch die Blende abgedeckt wird, ist durch Änderung der Ausrichtung der Blende veränderbar. Insbesondere kann dies von einem externen Beobachter wahrnehmbar sein, der entgegen der Abstrahlrichtung auf die Blende und den Reflektor der strahlungsemittierenden Vorrichtung blickt.

Die Blende kann weiterhin zumindest eine Öffnung aufweisen, deren Ausrichtung relativ zum strahlungsemittierenden Bauelement und zum Reflektor veränderbar ist. Die Öffnung kann beispielsweise eine Form aufweisen, die an die Form des ersten Wellenlängenkonversionsstoffs und/oder - soweit vorhanden - an die Form des zweiten Wellenlängenkonversionsstoffs auf dem Reflektor angepasst ist. Der erste Wellenlängenkonversionsstoff oder der erste und der zweite Wellenlängenkonversionsstoff können beispielsweise einen polygonalen, etwa rechteckigen oder quadratischen, oder einen runden, etwa kreisförmigen oder elliptischen, Flächenbereich auf dem Reflektor oder eine Kombination daraus einnehmen. Die Öffnung kann einen Querschnitt aufweisen, durch den der erste Wellenlängenkonversionsstoff in einer bestimmten Ausrichtung der Blende relativ zum Reflektor vollständig oder nahezu vollständig von der dem Reflektor abgewandten Seite der Blende aus sichtbar ist. Die Öffnung kann somit einen polygonalen, etwa rechteckigen oder quadratischen, oder runden, etwa kreisförmigen oder elliptischen, Querschnitt oder eine Kombination daraus aufweisen.

Insbesondere kann zumindest ein Teil der vom Reflektor abgestrahlten Konversionsstrahlung, also der Konversionsstrahlung, die vom ersten und/oder - soweit vorhanden - vom zweiten Wellenlängenkonversionsstoff erzeugt und abgestrahlt wird, durch die Öffnung in Abstrahlrichtung der strahlungsemittierenden Vorrichtung abgestrahlt werden. Weiterhin kann die Blende auch eine Mehrzahl von Öffnungen aufweisen. Weist der Reflektor beispielsweise wie oben beschrieben eine Mehrzahl von ersten Teilbereichen mit einem ersten Wellenlängenkonversionsstoff und eine Mehrzahl von zweiten Teilbereichen mit einem zweiten Wellenlängenkonversionsstoff auf, die abwechselnd nebeneinander angeordnet sind, so kann die Blende eine Mehrzahl von Öffnungen aufweisen, die gleich der Mehrzahl der ersten und zweiten Teilbereiche ist. In einer bestimmten Ausrichtung der Blende kann jeweils eine der Mehrzahl der Öffnungen über einem der Mehrzahl der ersten Teilbereiche angeordnet sein. Dadurch kann die strahlungsemittierende Vorrichtung durch die Mehrzahl der Öffnungen Konversionsstrahlung abstrahlen, die vom ersten Wellenlängenkonversionsstoff in den ersten Teilbereichen erzeugt und abgestrahlt wird. In einer weiteren bestimmten Ausrichtung der Blende kann jeweils eine der Mehrzahl der Öffnungen über einem der Mehrzahl der zweiten Teilbereiche angeordnet sein. Dadurch kann die strahlungsemittierende Vorrichtung durch die Mehrzahl der Öffnungen Konversionsstrahlung abstrahlen, die vom zweiten Wellenlängenkonversionsstoff in den zweiten Teilbereichen erzeugt und abgestrahlt wird. Durch Veränderung der Ausrichtung der Blende zwischen diesen beiden bestimmten Ausrichtungen kann die Sekundärstrahlung veränderbare Anteile jeweils der durch den ersten Wellenlängenkonversionsstoff und der durch den zweiten Wellenlängenkonversionsstoff erzeugten Konversionsstrahlung aufweisen.

Die Ausrichtung der Blende kann durch eine Translation relativ zum strahlungsemittierenden Bauelement und zum Reflektor änderbar sein. Das bedeutet insbesondere, dass das strahlungsemittierende Bauelement und der Reflektor starr gelagert oder befestigt sind, während die Blende relativ dazu verschiebbar ist. Die Translation kann dabei beispielsweise entlang einer Geraden oder entlang einer gekrümmten Linie erfolgen. Beispielsweise kann die Translation auch auf einem kreisförmigen oder elliptischen Translationsweg erfolgen. Dazu kann die strahlungsemittierende Vorrichtung ein Führungselement wie etwa eine Führungsschiene oder einen Gleitmechanismus aufweisen, mittels dem die Blende mechanisch oder elektromechanisch verschiebbar ist. Eine Translation kann eine kontinuierliche Verschiebung oder eine Verschiebung in diskreten Schritten, beispielsweise vorgegeben durch eine Rasterung, umfassen oder sein.

Alternativ oder zusätzlich kann die Sekundärstrahlung durch eine Rotation der Blende relativ zum strahlungsemittierenden Bauelement und zum Reflektor änderbar sein. Das kann bedeuten, dass die Blende drehbar gelagert ist und das strahlungsemittierende Bauelement und der Reflektor relativ zur Umgebung starr und unbeweglich gelagert sind. Die Blende kann beispielsweise relativ zum Reflektor um eine Drehachse drehbar sein, die parallel oder senkrecht zu einer Erstreckungsrichtung des Reflektors ist. Beispielsweise kann die Drehachse senkrecht zu einer Ersteckungsrichtung des Reflektors, so dass Blende parallel zur Erstreckungsrichtung des Reflektors schwenkbar sein kann. Weiterhin kann die Blende relativ zum Reflektor um eine Drehachse drehbar sein, die beispielsweise parallel zu einer Erstreckungsrichtung des Reflektors ist, so dass die Blende relativ zum Reflektor mechanisch oder elektromechanisch verkippt werden kann. Dazu kann die strahlungsemittierende Vorrichtung ein Rotationselement wie etwa einen Dreh-, Schwenk- oder Klappmechanismus mit einer Drehachse wie etwa eine mechanische Welle, ein Gelenk oder ein Scharnier aufweisen. Eine Rotation kann eine kontinuierliche Drehung oder eine Drehung in diskreten Winkelschritten, beispielsweise vorgegeben durch eine Rasterung, umfassen oder sein.

Um ein möglichst präzise gewünschte Einstellbarkeit und Veränderbarkeit der Sekundärstrahlung zu erreichen, kann die strahlungsemittierende Vorrichtung insbesondere eine wie oben beschriebene Kombination von ersten, zweiten und/oder dritten Wellenlängenkonversionsstoffen mit einer geeigneten Ausrichtvorrichtung für die Blende aufweisen.

Die Blende kann in den vorab beschriebenen Ausführungsformen zwischen dem strahlungsemittierenden Bauelement und dem Reflektor angeordnet sein. Alternativ dazu kann das strahlungsemittierende Bauelement auch zwischen der Blende und dem Reflektor angeordnet sein.

Das strahlungsemittierende Bauelement kann als punktförmige, als linienförmige oder als flächige Strahlungsquelle ausgeführt sein. Insbesondere ein als linienförmige Strahlungsquelle ausgeführtes strahlungsemittierendes Bauelement kann dabei bevorzugt gestreckt, also parallel zu einer Geraden, aber auch gebogen ausgeführt sein. Beispielsweise kann das strahlungsemittierende Bauelement eine Fluoreszenzlampe umfassen, insbesondere eine Kaltkathodenfluoreszenzlampe ("cold cathode fluorescence lamp", CCFL), eine Heißkathodenfluoreszenzlampe ("hot cathode fluorescence lamp", HCFL), eine Fluoreszenzlampe mit externen Elektroden ("external electrode fluorescence lamp", EEFL) oder eine flächige Fluoreszenzlampe ("flat fluorescence lamp", FFL). Alternativ oder zusätzlich kann das strahlungsemittierende Bauelement eine Elektrolumineszenzfolie aufweisen oder sein. Weiterhin kann das strahlungsemittierende Bauelement ein strahlungsemittierendes Halbleiterbauelement wie eine Leuchtdiode oder eine Laserdiode umfassen oder sein. Das strahlungsemittierende Halbleiterbauelement kann dabei eine anorganische oder eine organische Leuchtdiode oder Laserdiode sein. Dabei kann es auch vorteilhaft sein, wenn die strahlungsemittierende Vorrichtung eine Mehrzahl von Leuchtdioden oder Laserdioden umfasst, die dieselbe oder jeweils verschiedene elektromagnetische Strahlung emittieren.

Ein als anorganische LED oder Laserdiode ausgeführtes strahlungsemittierendes Bauelement kann eine Epitaxieschichtenfolge, also eine epitaktisch gewachsene Halbleiterschichtenfolge, aufweisen. Dabei kann die Halbleiterschichtenfolge beispielsweise auf der Basis eines anorganischen Materials, etwa von InGaAlN, wie etwa GaN-Dünnfilm-Halbleiterchips, ausgeführt sein. Unter InGaAlNbasierte beziehungsweise Nitrid-basierte Halbleiterchips fallen insbesondere solche, bei denen die epitaktisch hergestellte Halbleiterschichtenfolge, die in der Regel eine Schichtenfolge aus unterschiedlichen Einzelschichten aufweist, mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x+y ≤ 1 aufweist. Alternativ oder zusätzlich kann die Halbleiterschichtenfolge auch auf InGaAlP basieren, also Phosphid-basiert sein, das heißt, dass die Halbleiterschichtenfolge unterschiedliche Einzelschichten aufweist, wovon mindestens eine Einzelschicht ein Material aus dem III-V-Verbindungshalbleitermaterialsystem InₓAlyGa_{1-x-y}P mit 0 ≤ x ≤ 1, 0 ≤ y ≤ 1 und x+y ≤ 1 aufweist. Alternativ oder zusätzlich kann die Halbleiterschichtenfolge auch andere III-V-Verbindungshalbleitermaterialsysteme, beispielsweise ein AlGaAs-basiertes Material, oder II-VI-Verbindungshalbleitermaterialsysteme aufweisen. Ein II-VI-Verbindungshalbleitermaterialsystem kann wenigstens ein Element aus der zweiten Hauptgruppe, wie beispielsweise Be, Mg, Ca, Sr, und ein Element aus der sechsten Hauptgruppe, wie beispielsweise O, S, Se, aufweisen. Insbesondere umfasst ein II-VI-Verbindungshalbleitermaterialsystem eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Beispielsweise gehören zu den II-VI-Verbindungshalbleitermaterialsystemen: ZnO, ZnMgO, CdS, ZnCdS, MgBeO.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Die Halbleiterschichtenfolge kann neben dem aktiven Bereich weitere funktionale Schichten und funktionelle Bereiche umfassen, etwa p- oder n-dotierte Ladungsträgertransportschichten, also Elektronen- oder Löchertransportschichten, p-, n- oder undotierte Confinement- oder Cladding-Schichten, Barriereschichten, Planarisierungsschichten, Pufferschichten, Schutzschichten und/oder Elektroden sowie Kombinationen daraus. Solche Strukturen den aktiven Bereich oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

Beispielsweise kann das strahlungsemittierende Bauelement elektromagnetische Primärstrahlung im ultravioletten Spektralbereich und/oder im blauen Spektralbereich abstrahlen. Die Primärstrahlung kann dabei eine oder mehrere Wellenlängen im Bereich von etwa 365 Nanometer bis etwa 490 Nanometer umfassen.

Das strahlungsemittierende Bauelement kann bei der hier beschriebenen strahlungsemittierenden Vorrichtung im Betrieb unverändert und dauerhaft mit optimalem Wirkungsgrad und/oder mit voller Helligkeit betrieben werden, was sowohl bei Fluoreszenzlampen wie auch bei Halbleiterbauelementen eine hohe Zuverlässigkeit und Lebensdauer ermöglich kann.

Weiterhin kann die hier beschriebene strahlungsemittierende Vorrichtung auch geeignet sein, in einem ausgeschalteten Betriebszustand einen veränderbaren Beitrag beispielsweise zur Raumbeleuchtung oder zur Farbtemperatur eines Raumes beizutragen. Dazu kann die strahlungsemittierende Vorrichtung in einem Raum angebracht werden und der erste Wellenlängenkonversionsstoff und/oder - soweit vorhanden - der zweite und/oder der dritte Wellenlängenkonversionsstoff können durch in dem Raum vorhandenes Umgebungslicht, etwa Sonnenlicht, zur Abstrahlung von Konversionsstrahlung angeregt werden. Durch Veränderung der Ausrichtung der Blende relativ zum Reflektor kann die Konversionsstrahlung wie oben beschrieben im eingeschalteten Betriebszustand der strahlungsemittierenden Vorrichtung veränderbar sein, wodurch die auch im ausgeschalteten Zustand abstrahlbare Sekundärstrahlung in Form der Konversionsstrahlung veränderbar sein kann.

Weitere Vorteile und vorteilhafte Ausführungsformen und Weiterbildungen der Erfindung ergeben sich aus den im Folgenden in Verbindung mit den Figuren 1A bis 5B beschriebenen Ausführungsformen.

Es zeigen:
- Figuren 1A bis 1C: schematische Darstellungen einer strahlungsemittierenden Vorrichtung gemäß einem Ausführungsbeispiel und
- Figuren 2 bis 5B: schematische Darstellungen von strahlungsemittierenden Vorrichtungen gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

Hier und im Folgenden sind in den Ausführungsbeispielen die gezeigten strahlungsemittierenden Vorrichtungen der Übersichtlichkeit halber ohne Gehäuse, mechanische Haltevorrichtungen, mechanische oder elektromechanische Verschiebe- und/oder Drehvorrichtungen und ohne elektrische oder elektronische Versorgungs- und/oder Steuerelemente gezeigt, welche als dem Fachmann bekannt angenommen werden. Allen Ausführungsbeispielen ist gemein, dass der Reflektor 2 sowie das oder die strahlungsemittierenden Bauelemente 1 starr gelagert sind und lediglich die Blende 3 in ihrer Ausrichtung relativ zum Reflektor 2 und dem oder den strahlungsemittierenden Bauelementen 1 veränderbar ist.

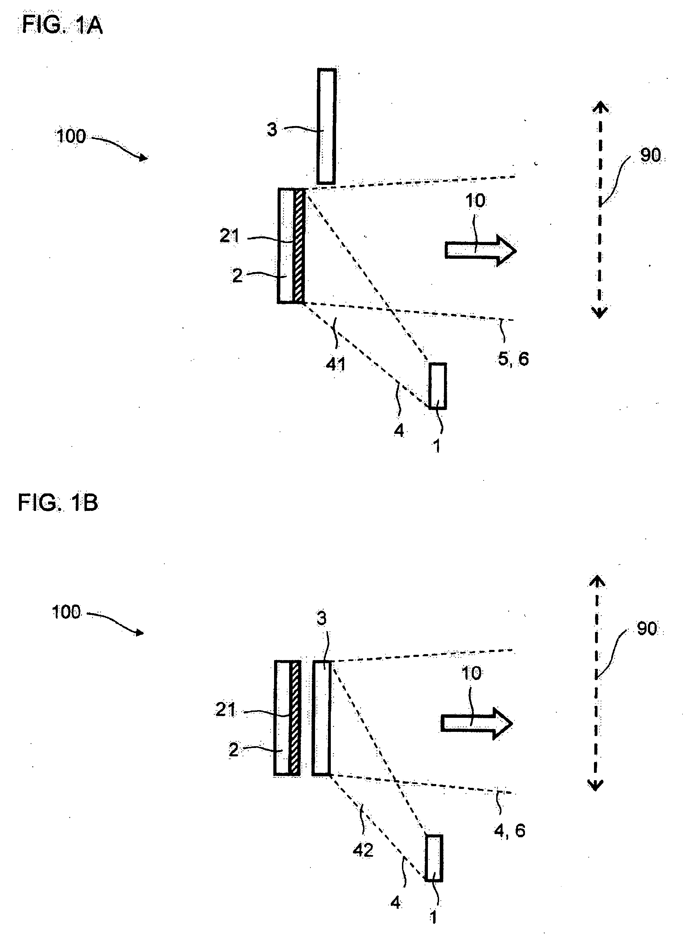

In den Figuren 1A bis 1C ist ein Ausführungsbeispiel für eine strahlungsemittierende Vorrichtung 100 gezeigt. Die strahlungsemittierende Vorrichtung 100 weist ein strahlungsemittierendes Bauelement 1 auf, das im Betrieb elektromagnetische Primärstrahlung 4 emittiert. Das strahlungsemittierende Bauelement 1 weist im gezeigten Ausführungsbeispiel eine anorganische, Nitrid-basierte Laserdiode auf, die eine Primärstrahlung 4 mit einem blauen Leuchteindruck und spektralen Komponenten mit einer Wellenlänge im Bereich von etwa 365 bis 490 Nanometer abstrahlt.

Durch Verwendung einer Laserdiode im strahlungsemittierenden Bauelement 1 kann die Primärstrahlung 4 mit einer hohen Intensität und mit einem kollimierbaren Strahl mit geringer Divergenz abgestrahlt werden. Für Anwendungen, die eine hohe Leuchtkraft erfordern, kann das strahlungsemittierende Bauelement 1 auch eine Mehrzahl von Laserdioden, etwa einen Laserdiodenbarren oder ein Laserdioden-Array, aufweisen. Alternativ dazu kann das strahlungsemittierende Bauelement 1 beispielsweise auch eine oder mehrere LEDs oder Fluoreszenzlampen aufweisen. Weiterhin weist das strahlungsemittierende Bauelement 1 ein Gehäuse und optische Komponenten zur Kollimierung der Primärstrahlung 4, die, wie oben erwähnt, der Übersichtlichkeit halber nicht gezeigt sind.

Die Primärstrahlung 4 wird auf einen Reflektor 2 abgestrahlt. Der Reflektor 2 weist eine diffus reflektierende, weiße Oberfläche auf, die dem strahlungsemittierenden Bauelement 1 zugewandt ist. Dadurch ist der Reflektor 2 derart ausgebildet, dass elektromagnetische Strahlung unabhängig von ihrer Wellenlänge diffus, also ohne Vorzugsrichtung, vom Reflektor umgelenkt werden kann. Dazu weist der Reflektor 2 auf der dem strahlungsemittierenden Bauelement 1 zugewandten Oberfläche eine Aufrauung auf. Alternativ oder zusätzlich können auf dem Reflektor 2, wie oben beschrieben, auch Streupartikel aufgebracht sein.

Auf dem Reflektor 2 ist ein erster Wellenlängenkonversionsstoff 21 aufgebracht, der die Primärstrahlung zumindest teilweise in eine elektromagnetische Konversionsstrahlung 5 umwandeln kann. Dazu weist der erste Wellenlängenkonversionsstoff 21 einen oder mehrere der oben im allgemeinen Teil beschriebenen Materialien auf, die in einem transparente Matrixmaterial eingebettet auf dem Reflektor 2 angeordnet sind. Die Konversionsstrahlung 5, die vom ersten Wellenlängenkonversionsstoff 21 abgestrahlt wird, weist im gezeigten Ausführungsbeispiel eine gelbe Wellenlänge auf. Die Zusammensetzung und die Konzentration des ersten Wellenlängenkonversionsstoffs 21 sowie die Dicke, mit der der erste Wellenlängenkonversionsstoff 21 auf dem Reflektor 2 aufgebracht ist, ist derart gewählt, dass die auf den Reflektor 2 eingestrahlte Primärstrahlung 4 gänzlich in Konversionsstrahlung 5 ungewandelt wird. "Gänzlich umgewandt" heißt hierbei, dass vom Reflektor 2 mit dem ersten Wellenlängenkonversionsstoff 21 weniger als 1/e, bevorzugt weniger als 1/e² und besonders bevorzugt weniger als 1% der Primärstrahlung 4 abgestrahlt wird, wobei e die Eulersche Zahl bezeichnet. Insbesondere wenn die Primärstrahlung 4 spektrale Komponenten aus einem ultravioletten Wellenlängenbereich aufweist, ist es beispielsweise aus gesundheitlichen Gründen für einen externen Beobachter vorteilhaft, wenn der vom Reflektor 2 und damit von der strahlungsemittierenden Vorrichtung 100 abgestrahlte Anteil der Primärstrahlung 4 möglichst gering ist.

Weiterhin weist die strahlungsemittierende Vorrichtung 100 eine Blende 3 auf, die in ihrer Ausrichtung relativ zum strahlungsemittierenden Bauelement 1 und zum Reflektor 2 veränderbar ist. Im gezeigten Ausführungsbeispiel ist die Blende 3 auf einem Translationsweg beziehungsweise einer Verschieberichtung, die durch den Doppelpfeil 90 angedeutet ist, relativ zum strahlungsemittierenden Bauelement 1 und zum Reflektor 2 verschiebbar. Dabei ist die Blende 3 zwischen dem Reflektor 2 und dem strahlungsemittierenden Bauelement 1 angeordnet, so dass die Blende 3 je nach relativer Ausrichtung zumindest einen Teil des Reflektor 2 aus Sicht des strahlungsemittierenden Bauelements 1 abdecken und damit abschatten kann. Die strahlungsemittierende Vorrichtung 100 weist zur Veränderung der Ausrichtung der Blende 3 einen mechanischen oder elektromechanischen Verschiebe- und/oder Gleitmechanismus wie etwa eine Schiene auf, der aus Gründen der Übersichtlichkeit nicht gezeigt ist. Alternativ oder zusätzlich kann die Blende 3 relativ zum strahlungsemittierenden Bauelement 1 und zum Reflektor 3 auch rotierbar sein. Die strahlungsemittierende Vorrichtung 100 kann dazu einen Schwenk-, Kipp- und/oder Drehmechanismus beispielsweise in Form einer Drehachse, eines Scharniers und/oder eines Gelenks aufweisen.

Die Blende ist weist im gezeigten Ausführungsbeispiel wie der Reflektor eine diffus reflektierende, weiße Oberfläche auf, die dem strahlungsemittierenden Bauelement 1 zugewandt ist. Dadurch kann zumindest der sichtbare Anteil der Primärstrahlung 4, der auf die Blende 3 eingestrahlt wird, unabhängig von der Wellenlänge diffus reflektiert werden. Weist die Primärstrahlung 4 zumindest eine spektrale Komponente aus einem ultravioletten Wellenlängenbereich auf, so kann es vorteilhaft sein, wenn die Blende 3 weiterhin für ultraviolette Strahlung absorbierend ist, so dass nur sichtbares Licht von der Blende 3 reflektiert wird. Die Blende 3 kann dazu beispielsweise eine UV-Filterschicht auf der dem strahlungsemittierenden Bauelement 1 zugewandten Oberfläche aufweisen.

Der Reflektor 2 und die Blende 3 sind im gezeigten eben ausgeführt. Alternativ dazu können der Reflektor 2 und/oder die Blende 3 auch gekrümmt beziehungsweise gebogen ausgeführt sein. Insbesondere der Reflektor 2 kann beispielsweise auch in Form eines Hohlspiegels mit gerichteter oder diffuser Reflexion ausgeführt sein. Dazu kann der Reflektor 2 in Form eines Teils eine Hohlzylinders, einer Hohlkugel, eines Rotationsellipsoiden, Rotationsparaboloiden, Rotationshyperboloiden oder einer Kombination daraus ausgebildet sein, wobei die dem strahlungsemittierenden Bauelement 1 zugewandte Oberfläche des Reflektors 2 mit dem ersten Wellenlängenkonversionsstoff 21 konvex oder konkav ausgebildet sein kann.

Die strahlungsemittierende Vorrichtung 100 strahlt im Betrieb des strahlungsemittierenden Bauelements 1 in die mittels des Pfeils 10 angedeutete Abstrahlrichtung elektromagnetische Sekundärstrahlung 6 ab, die in Abhängigkeit von der Ausrichtung der Blende 3 relativ zum strahlungsemittierenden Bauelement 1 und zum Reflektor 2 veränderbar ist. In den Figuren 1A bis 1C sind drei verschiedene Ausrichtungen der Blende 3 gezeigt, anhand derer rein beispielhaft die Veränderbarkeit und Einstellbarkeit der Sekundärstrahlung 6 im Folgenden erläutert wird.

In Figur 1A ist die Blende 3 gemäß einer ersten Ausrichtung derart relativ zum Reflektor 2 ausgerichtet, dass die gesamte Primärstrahlung 4 auf den ersten Wellenlängenkonversionsstoff 21 eingestrahlt wird. Der Anteil 41 der Primärstrahlung 4, der vom ersten Wellenlängenkonversionsstoff 21 in Konversionsstrahlung 5 umgewandelt werden kann, umfasst somit in der ersten Ausrichtung die gesamte Primärstrahlung 4. Die strahlungsemittierende Vorrichtung 100 strahlt somit in der ersten Ausrichtung gemäß Figur 1A als Sekundärstrahlung 6 die Konversionsstrahlung 5 ab. Die Sekundärstrahlung 6 weist somit in der ersten Ausrichtung der Blende 3 Primärstrahlung 4 mit einem Anteil von Null auf.

In Figur 1B ist die Blende 3 in einer zweiten Ausrichtung relativ zum Reflektor 3 gezeigt, in der die Blende 3 den Reflektor 2 und damit auch den ersten Wellenlängenkonversionsstoff 21 komplett abschattet. Der Anteil 42 der Primärstrahlung 4, der auf die Blende 3 eingestrahlt wird, umfasst somit die gesamte Primärstrahlung 4, während der Anteil der Primärstrahlung 4, der in Konversionsstrahlung umgewandelt wird, in der zweiten Ausrichtung gemäß Figur 1B gleich Null ist. Dadurch strahlt die strahlungsemittierende Vorrichtung 100 in der zweiten Ausrichtung als Sekundärstrahlung 6 die von der Blende 3 reflektierte Primärstrahlung 4 ab, der, wie oben beschrieben, im gezeigten Ausführungsbeispiel der gesamte sichtbare Anteil der Primärstrahlung 4 sein kann.

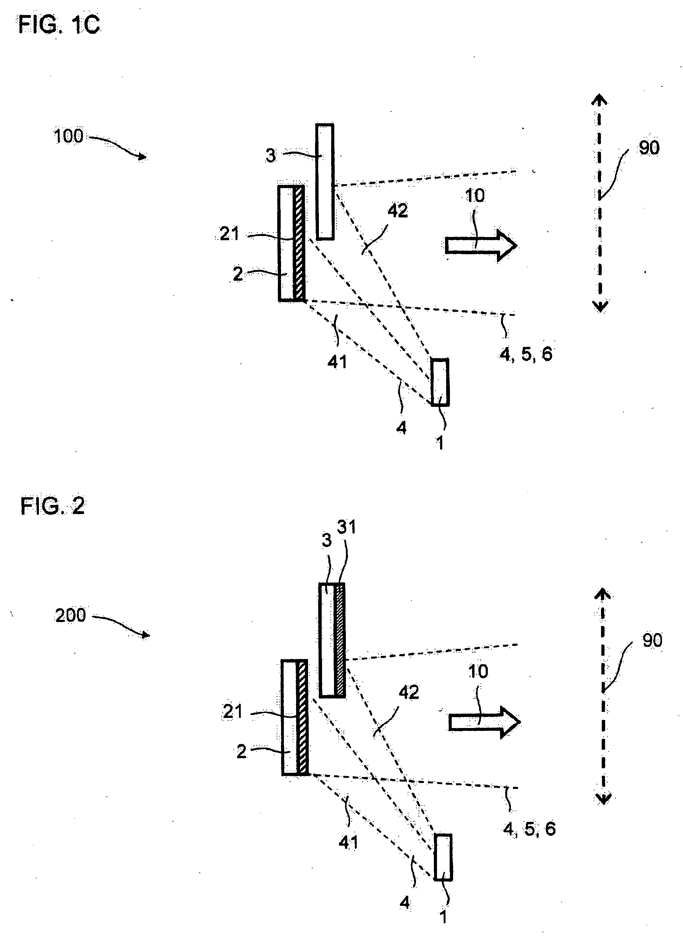

Die Blende 3 kann zwischen der ersten Ausrichtung gemäß Figur 1A und der zweiten Ausrichtung gemäß Figur 1B entlang der Verschieberichtung 90 kontinuierlich verändert werden, wie in Figur 1C angedeutet ist. Damit kann die Blende 3 Ausrichtungen einnehmen, die zwischen der ersten und zweiten Ausrichtung liegen. In der Ausrichtung der Blende 3 gemäß der Figur 1C schattet die Blende 3 den Reflektor 2 und damit den ersten Wellenlängenkonversionsstoff 21 teilweise ab, so dass ein erster Anteil 41 der Primärstrahlung 4 auf den ersten Wellenlängenkonversionsstoff 21 und ein weiterer, zweiter Anteil 42 der Primärstrahlung 4 auf die Blende 3 eingestrahlt wird. Die Sekundärstrahlung 6 umfasst in der Ausrichtung der Blende 3 gemäß Figur 1C somit die über den veränderbaren ersten Anteil 41 ebenfalls veränderbare Konversionsstrahlung 5, die vom ersten Wellenlängenkonversionsstoff 21 abgestrahlt wird, und den zweiten Anteil 42 der Primärstrahlung 4, der von der Blende 3 reflektiert wird.

Es sei ausdrücklich darauf hingewiesen, dass die Anteile 41 und 42 in der Figur 1C lediglich zum besseren Verständnis durch die gestrichelten Linien angedeutet sind. Der erste und zweite Anteil 41, 42 der Primärstrahlung 4 hängen dabei von der Ausführung des strahlungsemittierenden Bauelements 1 und insbesondere der Abstrahlcharakteristik des strahlungsemittierenden Bauelements 1 ab.

Insbesondere können sich auch die vom ersten Wellenlängenkonversionsstoff 21 abgestrahlte Konversionsstrahlung 5 und die von der Blende 3 reflektierte Primärstrahlung 4 zumindest teilweise oder auch deckungsgleich überlagern, so dass die Sekundärstrahlung 6 eine homogene Überlagerung und Mischung der Primärstrahlung 4 und der Konversionsstrahlung 5 aufweisen kann.

Die Sekundärstrahlung 6 ist somit veränderbar durch Veränderung des ersten Anteils 41 der Primärstrahlung 4, der vom strahlungsemittierenden Bauelement 1 auf den ersten Wellenlängenkonversionsstoff 21 abgestrahlt wird, und durch Veränderung der abgestrahlten Konversionsstrahlung 5 mittels Veränderung der Ausrichtung der Blende 3. Der Leuchteindruck der Sekundärstrahlung 6 kann dabei im gezeigten Ausführungsbeispiel zwischen blau und gelb kontinuierlich variiert werden. Insbesondere in Ausrichtungen der Blende 3 gemäß Figur 1C zwischen der ersten Ausrichtung gemäß Figur 1A und der zweiten Ausrichtung gemäß Figur 1B kann die Sekundärstrahlung 6 durch Überlagerung der blauen Primärstrahlung 4 und der gelben Konversionsstrahlung 5 einen weißfarbigen Leuchteindruck mit veränderbarer Farbtemperatur oder veränderbarer korrelierter Farbtemperatur erwecken.

Besonders bei der Verwendung von einer oder mehreren blauen LEDs oder Laserdioden als strahlungsemittierendes Bauelement 1 ergibt sich für die strahlungsemittierende Vorrichtung 100 ein deutlicher Kostenvorteil gegenüber bekannten Beleuchtungseinrichtung mit veränderbarer Farbabstrahlung, da das oder die strahlungsemittierende Bauelemente 1 mit voller Helligkeit betrieben werden können und dennoch die Farbe des Leuchteindrucks der Sekundärstrahlung 6 mittels der Blende 3 einstellbar ist. Weiterhin kann, da auch bei mehreren strahlungsemittierenden Bauelementen 1 nur eine Primärstrahlung 4 verwendet wird, eine aufwändige Farbregelung ("color management system") vermieden und damit eingespart werden.

In den folgenden Figuren sind Ausführungsbeispiele für strahlungsemittierende Vorrichtungen gezeigt, die Modifikationen und/oder Erweiterungen der strahlungsemittierenden Vorrichtung 100 des Ausführungsbeispiels gemäß den Figuren 1A bis 1C umfassen. Die nachfolgende Beschreibung bezieht sich daher hauptsächlich auf die Unterschiede im Vergleich zur strahlungsemittierenden Vorrichtung 100.

In Figur 2 ist ein Ausführungsbeispiel für eine strahlungsemittierende Vorrichtung 200 gezeigt, die eine Modifikation der strahlungsemittierenden Vorrichtung 100 darstellt. Im Vergleich zum vorherigen Ausführungsbeispiel ist das strahlungsemittierende Bauelement 1 derart ausgeführt, dass die Primärstrahlung 4 nur blaues Licht mit spektralen Komponenten mit einer Wellenlänge zwischen etwa 465 und 480 Nanometern umfasst.

Der Reflektor 2 und der erste Wellenlängenkonversionsstoff 21 sind derart ausgeführt, dass der auf den Reflektor 2 und den ersten Wellenlängenkonversionsstoff 21 eingestrahlte erste Anteil 41 der Primärstrahlung 4 teilweise in Konversionsstrahlung 5 mit spektralen Komponenten in einem gelben Wellenlängenbereich umgewandelt wird und auch ein Teil der Primärstrahlung 4 vom Reflektor 2 reflektiert wird. Dadurch strahlt der Reflektor 2 elektromagnetische Strahlung ab, die eine Überlagerung von Primärstrahlung 4 und von Konversionsstrahlung 5 ist und die einen kaltweißen Leuchteindruck bei einem externen Beobachter erwecken kann. Als "kaltweiß" wird hier und im Folgenden elektromagnetische Strahlung bezeichnet, die eine Farbtemperatur oder eine korrelierte Farbtemperatur von mehr als etwa 5500 Kelvin aufweist. Die Farbtemperatur von etwa 5500 Kelvin entspricht dabei einem Schwarzkörperstrahler mit einem Emissionsspektrum mit Farbkoordinaten von x = y = 1/3 in der dem Fachmann bekannten CIE-1931-Normfarbtafel.

Die Blende 3 weist einen dritten Wellenlängenkonversionsstoff 31 auf einer dem strahlungsemittierenden Bauelement 1 zugewandten Oberfläche auf, der geeignet ist, die Primärstrahlung 4 zumindest teilweise in Konversionsstrahlung 5 mit spektralen Komponenten im grünen und/oder gelben und im roten Wellenlängenbereich umzuwandeln. Der dritte Wellenlängenkonversionsstoff 31 ist hinsichtlich seiner Materialauswahl, Konzentration und Dicke auf der Blende 3 derart ausgewählt, dass ein Teil des Anteils 42 der Primärstrahlung 4, der auf die Blende 3 und den dritten Wellenlängenkonversionsstoff 31 eingestrahlt wird, von der Blende 3 unkonvertiert reflektiert werden kann. Dadurch kann von der Blende 3 eine Überlagerung aus der blauen Primärstrahlung 4 und der grünen und/oder gelben und roten Konversionsstrahlung 5 abgestrahlt werden, die einen warmweißen Leuchteindruck bei einem externen Beobachter erwecken kann.

Durch die Veränderung der Ausrichtung der Blende 3 relativ zum strahlungsemittierenden Bauelement 1 und zum Reflektor 2 können somit der erste Anteil 41 der Primärstrahlung, der auf den Reflektor 2 und den ersten Wellenlängenkonversionsstoff 21 eingestrahlt wird, und der zweite Anteil 42 der Primärstrahlung 4, der auf die Blende 3 und den dritten Wellenlängenkonversionsstoff 31 eingestrahlt wird, relativ zueinander verändert werden. Dadurch kann der Anteil der elektromagnetischen Strahlung mit einem kaltweißen Leuchteindruck vom Reflektor 2 und der Anteil der elektromagnetischen Strahlung mit einem warmweißen Leuchteindruck von der Blende 3 relativ zueinander geändert werden. Durch Veränderung der Ausrichtung der Blende 3 kann somit die Farbtemperatur beziehungsweise die korrelierte Farbtemperatur der Sekundärstrahlung 6, die von der strahlungsemittierenden Vorrichtung 200 in Abstrahlrichtung 10 abgestrahlt wird, verändert werden, ohne dass die Abstrahlintensität des strahlungsemittierenden Bauelements 1 geändert werden muss.

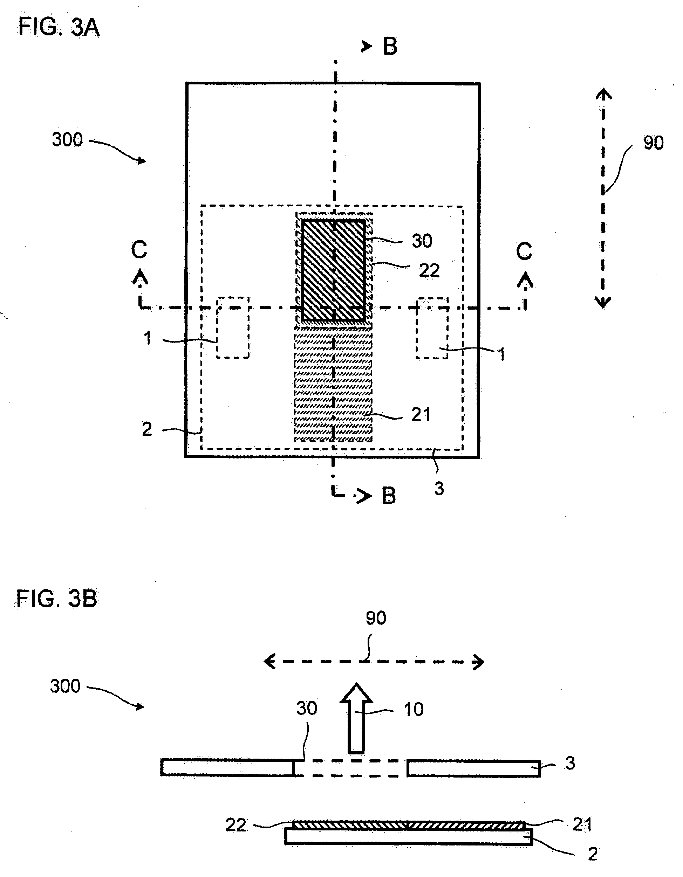

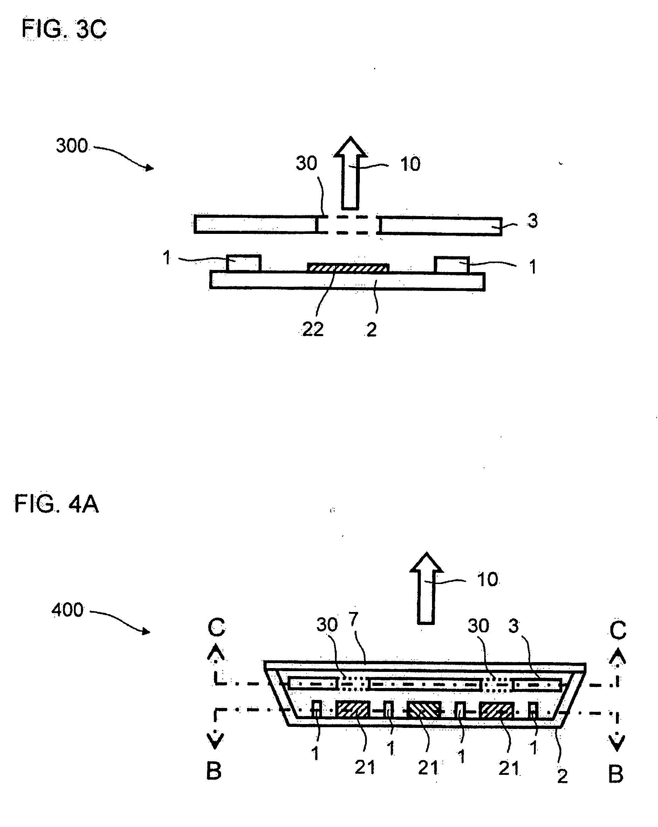

In den Figuren 3A bis 3C ist ein weiteres Ausführungsbeispiel für eine strahlungsemittierende Vorrichtung 300 gezeigt. Dabei ist in Figur 3A eine Draufsicht auf die strahlungsemittierende Vorrichtung 300 entgegen der Abstrahlrichtung 10 gezeigt. In den Figuren 3B und 3C sind schematische Schnittdarstellungen entlang der in Figur 3A mit BB und CC gekennzeichneten Schnittebenen gezeigt. Die nachfolgende Beschreibung bezieht sich gleichermaßen auf die Figuren 3A bis 3C.

Die strahlungsemittierende Vorrichtung 300 weist einen Reflektor 2 auf, auf dem ein erster Wellenlängenkonversionsstoff 21 und dazu benachbart ein zweiter Wellenlängenkonversionsstoff 22 angeordnet ist. Der zweite Wellenlängenkonversionsstoff 22 ist dabei verschieden vom ersten Wellenlängenkonversionsstoff 21. Weiterhin sind auf dem Reflektor 2 zwei strahlungsemittierende Bauelemente 1 angeordnet, die als LEDs zur Abstrahlung von blauer Primärstrahlung ausgeführt sind.

Über dem Reflektor 2 ist eine Blende 3 angeordnet, die reflektierend für die Primärstrahlung ist, so dass Primärstrahlung, die von den strahlungsemittierenden Bauelementen 1 in Richtung der reflektierenden Blende 3 abgestrahlt wird, von dieser zu den Wellenlängenkonversionsstoffen 21, 22 reflektiert wird. Die Blende 3 weist eine Öffnung 30 auf, die an die Form des ersten und zweiten Wellenlängenkonversionsstoffs 21, 22 derart angepasst ist, dass für einen externer Beobachter, wie in Figur 3A gezeigt, in einer Blickrichtung entgegen der Abstrahlrichtung 10 durch die Öffnung 30 der erste und/oder den zweite Wellenlängenkonversionsstoff 21, 22 sichtbar ist. Im gezeigten Ausführungsbeispiel sind der erste und zweite Wellenlängenkonversionsstoff 21, 22 sowie die Öffnung 30 jeweils rechteckig ausgeführt. Daneben sind jedoch auch andere Formen, wie etwa im allgemeinen Teil beschrieben, möglich. Durch die Änderung der Ausrichtung der Blende 3 relativ zum Reflektor 2 und zu den strahlungsemittierenden Bauelementen 1 kann aufgrund der Öffnung 30 der Blende 3 der Anteil der Primärstrahlung, der auf den ersten und auf den zweiten Wellenlängenkonversionsstoff 21, 22 jeweils eingestrahlt wird, verändert werden.

Im gezeigten Ausführungsbeispiel ist der erste Wellenlängenkonversionsstoff 21 wie im vorherigen Ausführungsbeispiel derart ausgeführt, dass die blaue Primärstrahlung in Konversionsstrahlung mit spektralen Komponenten im gelben Wellenlängenbereich umgewandelt wird. Der zweite Wellenlängenkonversionsstoff 22 ist wie im vorherigen Ausführungsbeispiel der dritte Wellenlängenkonversionsstoff 31 derart ausgeführt, dass die blaue Primärstrahlung in Konversionsstrahlung mit spektralen Komponenten im grünen und/oder gelben und im roten Wellenlängenbereich konvertiert wird. Da ein Teil des Reflektors 2 frei vom ersten und zweiten Wellenlängenkonversionsstoff 21, 22 ist, kann zumindest in diesem Teil die Primärstrahlung unkonvertiert reflektiert werden.

Die Blende 3 ist entlang des Translationswegs 90 relativ zum Reflektor 2 und zu den strahlungsemittierenden Bauelementen 1 verschiebbar. In der in Figur 3A beispielhaft gezeigten Ausrichtung der Blende 3 ist die Öffnung 30 nur über dem zweiten Wellenlängenkonversionsstoff 22 angeordnet. Dadurch werden durch die Öffnung 30 hauptsächlich die vom zweiten Wellenlängenkonversionsstoff 22 abgestrahlte Konversionsstrahlung sowie unkonvertierte Primärstrahlung abgestrahlt, so dass die strahlungsemittierende Vorrichtung 300 in Abstrahlrichtung 10 eine Sekundärstrahlung mit einem warmweißen Leuchteindruck abstrahlen kann. Wird die Ausrichtung der Blende 3 derart geändert, dass die Öffnung 30 nur über dem ersten Wellenlängenkonversionsstoff 21 angeordnet ist, wird durch die Öffnung 30 hauptsächlich die vom ersten Wellenlängenkonversionsstoff 21 abgestrahlte Konversionsstrahlung sowie unkonvertierte Primärstrahlung abgestrahlt. In dieser Ausrichtung der Blende 3 relativ zum Reflektor 2 kann die strahlungsemittierende Vorrichtung 300 Sekundärstrahlung mit einem kaltweißen Leuchteindruck abstrahlen. Wird die Öffnung 30 derart über dem ersten und zweiten Wellenlängenkonversionsstoff 21, 22 angeordnet, dass sowohl ein Teil des ersten als auch ein Teil des zweiten Wellenlängenkonversionsstoffs 21, 22 durch die Öffnung hindurch sichtbar sind, kann die strahlungsemittierende Vorrichtung 300 Sekundärstrahlung abstrahlen, die eine Überlagerung aus elektromagnetischer Strahlung mit einem kaltweißen und einem warmweißen Leuchteindruck ist.

Durch eine kontinuierliche Veränderung der Ausrichtung der Blende 3 und damit der Öffnung 30 relativ zum Reflektor 2 und zu den strahlungsemittierenden Bauelementen 1 kann somit die Sekundärstrahlung kontinuierlich hinsichtlich ihres Leuchteindrucks verändert werden, ohne dass die Abstrahlintensität der strahlungsemittierenden Bauelemente 1 geändert werden muss. Weiterhin können gleichartige strahlungsemittierende Bauelemente 1 verwendet werden, die die gleiche oder zumindest eine ähnliche Primärstrahlung emittieren.

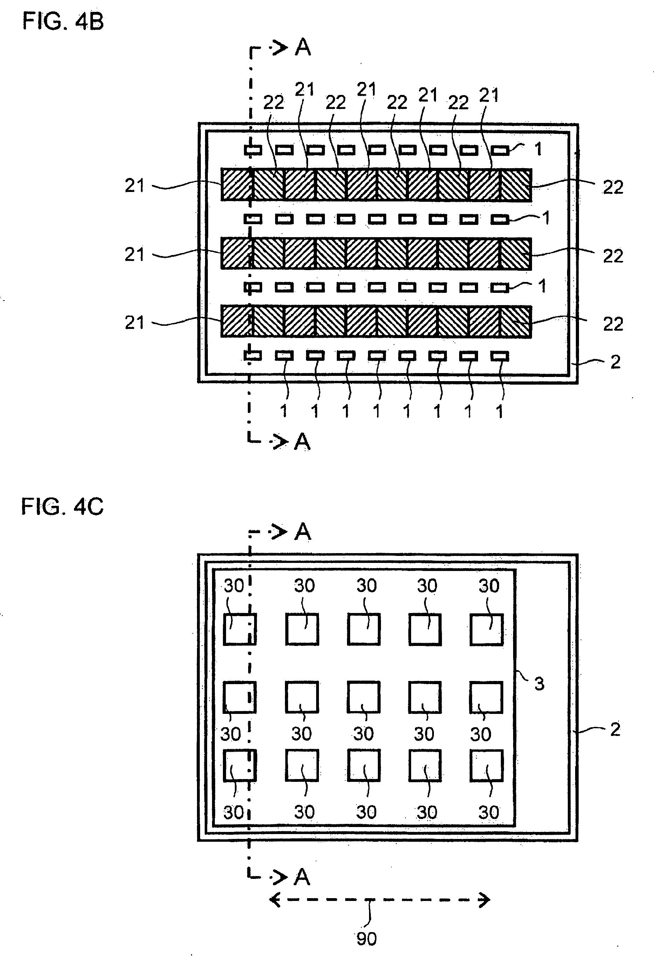

In den Figuren 4A bis 4C ist ein Ausführungsbeispiel für eine strahlungsemittierende Vorrichtung 400 gezeigt. In den Figuren 4B und 4C sind schematische Schnittdarstellung entlang der in Figur 4A mit BB und CC bezeichneten Schnittebenen gezeigt. In den Figuren 4B und 4C kennzeichnet die Schnittebene AA den in Figur 4A dargestellten Schnitt durch die strahlungsemittierende Vorrichtung 400.

Die strahlungsemittierende Vorrichtung 400 ist dabei ähnlich wie die strahlungsemittierende Vorrichtung 300 im vorherigen Ausführungsbeispiel ausgeführt. Im Gegensatz zur strahlungsemittierenden Vorrichtung 300 weist die strahlungsemittierende Vorrichtung 400 jedoch einen als Lichtkasten ausgeführten Reflektor 2 auf, in dem eine Mehrzahl von ersten Wellenlängenkonversionsstoffen 21 und eine Mehrzahl von zweiten Wellenlängenkonversionsstoffen 22 in ersten und zweiten Teilbereichen des Reflektors 2 angeordnet sind. Die ersten und zweiten Teilbereiche mit den ersten und zweiten Wellenlängenkonversionsstoffen 21, 22 sind dabei entlang von parallelen Geraden abwechselnd nebeneinader auf dem Reflektor 2 aufgebracht.

Weiterhin sind auf dem Reflektor 2 entlang von parallelen Geraden, also zeilenförmig, jeweils Mehrzahlen von strahlungsemittierenden Bauelementen 1, die als LEDs oder Laserdioden ausgeführt sind, angeordnet. Alternativ oder zusätzlich können auch strahlungsemittierende Bauelemente 1 als Fluoreszenzlampen, wie im allgemeinen Teil beschrieben, ausgeführt sein.

Über den strahlungsemittierenden Bauelementen 1 und den Teilbereichen mit den ersten und zweiten Wellenlängenkonversionsstoffen 21, 22 ist eine verschiebbare, reflektierende Blende 3 angeordnet, die eine Mehrzahl von Öffnungen 30 aufweist. Dabei ist jede der Öffnungen 30 einem Paar von benachbarten ersten und zweiten Wellenlängenkonversionsstoffen 21, 22 zugeordnet, so dass die von der strahlungsemittierenden Vorrichtung 400 abgestrahlte Sekundärstrahlung nach demselben Prinzip wie im Falle der strahlungsemittierenden Vorrichtung 300 gemäß der Figuren 3A bis 3C veränderbar ist.

Über der Blende 3 ist in Abstrahlrichtung 10 ein Diffusor 7 angeordnet, der eine Durchmischung der durch die Öffnungen 30 abgestrahlten elektromagnetischen Strahlung ermöglicht und damit eine homogene Abstrahlung der Sekundärstrahlung sicherstellt. Der Diffusor 7 ist dabei als Streuplatte mit einer transluzenten, also lichtdurchlässigen aber nicht durchsichtigen, Oberfläche in Form einer Milchglasscheibe ausgeführt.

Weiterhin kann eine strahlungsemittierende Vorrichtung auch eine Mehrzahl von ersten Wellenlängenkonversionsstoffen 21 und strahlungsemittierenden Bauelementen 1 aufweisen und eine Veränderbarkeit der Sekundärstrahlung nach dem Prinzip der strahlungsemittierenden Vorrichtungen 100 und 200 gemäß der Figuren 1A bis 1C beziehungsweise 2 ermöglichen.

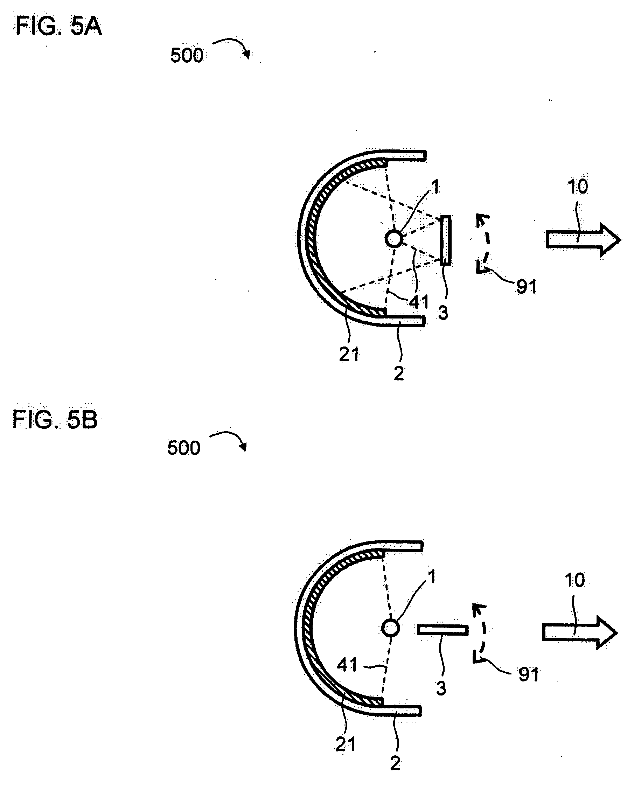

In den Figuren 5A und 5B ist ein Ausführungsbeispiel für eine strahlungsemittierende Vorrichtung 500 gezeigt, die einen gekrümmt ausgeführten Reflektor 2 aufweist. Auf der konkaven, einem strahlungsemittierenden Bauelement 1 zugewandten Oberfläche des Reflektors 2 ist ein erster Wellenlängenkonversionsstoff 21 angeordnet, der die Primärstrahlung zumindest teilweise in elektromagnetische Konversionsstrahlung umwandeln kann. Das strahlungsemittierende Bauelement 1 umfasst im gezeigten Ausführungsbeispiel eine Fluoreszenzlampe, die in der Zeichnungsebene isotrop eine Primärstrahlung abstrahlen kann. Alternativ dazu kann das strahlungsemittierende Bauelement 1 auch als radial abstrahlende LED oder LED-Array ausgeführt sein. Wie in den vorherigen Ausführungsbeispielen strahlt das strahlungsemittierende Bauelement 1 der strahlungsemittierenden Vorrichtung 500 elektromagnetische Primärstrahlung mit einem blauen Leuchteindruck ab, während der erste Wellenlängenkonversionsstoff 21 Konversionsstrahlung mit einem gelben oder gelblich-rotem Leuchteindruck abstrahlen kann.

Das strahlungsemittierende Bauelement 1 ist zwischen dem Reflektor 2 und einer Blende 3 angeordnet. Die Blende 3 ist gerichtet reflektierend ausgeführt und ist, angedeutet durch den Doppelpfeil 90, in der Zeichnungsebene drehbar. Der Übersichtlichkeit halber ist in den Figuren 5A und 5B nur der Anteil 41 der Primärstrahlung gezeigt, der direkt oder durch Reflexion an der Blende 3 auf den ersten Wellenlängenkonversionsstoff 21 eingestrahlt wird.

Der Anteil der Primärstrahlung, der nicht als Anteil 41 auf den ersten Wellenlängenkonversionsstoff 21 eingestrahlt wird, kann in Abstrahlrichtung 10 direkt abgestrahlt werden (nicht gezeigt). Die von der strahlungsemittierenden Vorrichtung 500 abgestrahlte Sekundärstrahlung setzt sich damit aus dem direkt abgestrahlten Anteil der Primärstrahlung und der vom ersten Wellenlängenkonversionsstoff 21 abgestrahlten Konversionsstrahlung zusammen. Durch Drehung der Blende 3 relativ zum strahlungsemittierenden Bauelement 1 und zum Reflektor 2, also durch Änderung der Ausrichtung der Blende 3 relativ zum strahlungsemittierenden Bauelement 1 und zum Reflektor 2, kann, wie in den Figuren 5A und 5B gezeigt, der Anteil 41 der Primärstrahlung, der auf den ersten Wellenlängenkonversionsstoff 21 eingestrahlt wird, verändert werden. Dadurch sind die Konversionsstrahlung sowie auch der Anteil der Primärstrahlung, der direkt in Abstrahlrichtung 10 abgestrahlt werden kann, durch Änderung der relativen Ausrichtung der Blende 3 veränderbar.

Durch Drehung der Blende 3 kann somit der Anteil der blauen Primärstrahlung und der Anteil der gelben Konversionsstrahlung an der Sekundärstrahlung verändert werden. Dadurch kann der Leuchteindruck der Sekundärstrahlung zwischen einem bläulicherem Farbeindruck in der Ausrichtung der Blende gemäß Figur 5B und einem gelblicheren oder einem gelblich-rötlicherem Farbeindruck in der Ausrichtung der Blende 3 gemäß Figur 5A verändert werden.

Alternativ zu der gerichtet reflektierend ausgeführten Blende 3 kann diese auf der in Figur 5A dem Reflektor zugewandten Oberfläche auch einen dritten Wellenlängenkonversionsstoff wie in Figur 2 aufweisen. Die von der Blende 3 auf den Reflektor 2 zurückgestrahlte, vom dritten Wellenlängenkonversionsstoff erzeugte Konversionsstrahlung kann am Reflektor 2 in Abstrahlrichtung 10 reflektiert werden und damit zur Sekundärstrahlung und deren Leuchteinruck je nach Ausrichtung der Blende beitragen.

Alternativ oder zusätzlich zu einer drehbaren Blende 3 kann die strahlungsemittierende Vorrichtung 500 auch eine verschiebbare oder eine dreh- und verschiebbare Blende aufweisen.

Die in Verbindung mit den Figuren 1A bis 5B beschriebenen Kombinationen von Wellenlängenbereichen für die Primärstrahlung und die Konversionsstrahlung sind rein beispielhaft. Daneben sind auch andere Kombinationen von Wellenlängenbereichen möglich, die Sekundärstrahlung mit einem veränderbaren weiß- und/oder mischfarbigen Leuchteindruck ermöglichen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

### Bezugszeichenliste

- 1: strahlungsemittierendes Bauelement (1)
- 2: Reflektor
- 3: Blende
- 4: Primärstrahlung
- 5: Konversionsstrahlung
- 6: Sekundärstrahlung
- 7: Diffusor
- 10: Abstrahlrichtung
- 21: erster Wellenlängenkonversionsstoff
- 22: zweiter Wellenlängenkonversionsstoff
- 30: Öffnung
- 31: dritter Wellenlängenkonversionsstoff
- 41, 42: Anteil der Primärstrahlung
- 90: Translation
- 91: Rotation
- 100: strahlungsemittierende Vorrichtung
- 200: strahlungsemittierende Vorrichtung
- 300: strahlungsemittierende Vorrichtung
- 400: strahlungsemittierende Vorrichtung
- 500: strahlungsemittierende Vorrichtung

## Patentansprüche

1. Strahlungsemittierende Vorrichtung zur Abstrahlung einer veränderbaren elektromagnetischen Sekundärstrahlung (6) in einer Abstrahlrichtung (10), umfassend
- zumindest ein strahlungsemittierendes Bauelement (1), das im Betrieb eine elektromagnetische Primärstrahlung (4) emittiert,
- einen Reflektor (2), der im Strahlengang des strahlungsemittierenden Bauelements (1) angeordnet ist und der einen ersten Wellenlängenkonversionsstoff (21) zur zumindest teilweisen Konversion der Primärstrahlung (4) in eine elektromagnetische Konversionsstrahlung (5) aufweist, **dadurch gekennzeichnet, dass**
- eine Blende (3), die in ihrer Ausrichtung relativ zum strahlungsemittierenden Bauelement (1) und zum Reflektor (2) veränderbar ist,
wobei
- mittels Veränderung der Ausrichtung der Blende (3) die Sekundärstrahlung (6) veränderbar ist durch Veränderung des Anteils (41) der Primärstrahlung (4), der vom strahlungsemittierenden Bauelement (1) auf den ersten Wellenlängenkonversionsstoff (2) abgestrahlt wird, und durch Veränderung der abgestrahlten Konversionsstrahlung (5).

2. Vorrichtung nach Anspruch 1, wobei
- der Reflektor (2) einen ersten Teilbereich mit dem ersten Wellenlängenkonversionsstoff (21) und einen zweiten Teilbereich mit einem zweiten, vom ersten Wellenlängenkonversionsstoff (21) verschiedenen Wellenlängenkonversionsstoff (22) zur Konversion der Primärstrahlung (4) in elektromagnetische Konversionsstrahlung (5) aufweist und
- durch Änderung der Ausrichtung der Blende (3) der vom ersten Teilbereich abgestrahlte Anteil und der vom zweiten Teilbereich abgestrahlte Anteil der Konversionsstrahlung (5) an der Sekundärstrahlung (6) relativ zueinander veränderbar sind.

3. Vorrichtung nach dem vorherigen Anspruch, wobei
- der Reflektor (2) eine Mehrzahl von ersten und zweiten Teilbereichen aufweist, die abwechselnd nebeneinander angeordnet sind.

4. Vorrichtung nach einem der vorherigen Ansprüche, wobei
- der Reflektor (2) teilweise reflektierend für die Primärstrahlung (4) ist.

5. Vorrichtung nach einem der vorherigen Ansprüche, wobei
- die Blende (3) zumindest teilweise reflektierend ausgebildet ist.

6. Vorrichtung nach einem der vorherigen Ansprüche, wobei
- die Blende (3) einen dritten Wellenlängenkonversionsstoff (31) aufweist und
- durch Änderung der Ausrichtung der Blende (3) der Anteil der Primärstrahlung (4), der vom strahlungsemittierenden Bauelement (1) auf den dritten Wellenlängenkonversionsstoff (31) eingestrahlt wird, veränderbar ist.

7. Vorrichtung nach einem der vorherigen Ansprüche, wobei
- die Blende (3) zumindest eine Öffnung (30) aufweist.

8. Vorrichtung nach dem vorherigen Anspruch, wobei
- von der strahlungsemittierenden Vorrichtung zumindest ein Teil der Konversionsstrahlung (5) durch die Öffnung (30) abgestrahlt wird.

9. Vorrichtung nach Anspruch 7 oder 8, wobei
- die Blende (3) eine Mehrzahl von Öffnungen (30) aufweist.

10. Vorrichtung nach einem der vorherigen Ansprüche, wobei
- die Ausrichtung der Blende (3) relativ zum strahlungsemittierenden Bauelement (1) durch eine Translation (90) und/oder eine Rotation (91) veränderbar ist.

11. Vorrichtung nach einem der vorherigen Ansprüche, wobei
- die Blende (3) von einem externen Beobachter aus gesehen zumindest einen Teil des Reflektors (2) abdeckt, der durch Änderungen der Anordnung der Blende (3) veränderbar ist.

12. Vorrichtung nach einem der Ansprüche 1 bis 11, wobei
- die Blende (3) zwischen dem strahlungsemittierenden Bauelement (1) und dem Reflektor (2) angeordnet ist.

13. Vorrichtung nach einem der Ansprüche 1 bis 11, wobei
- das strahlungsemittierende Bauelement (1) zwischen dem Reflektor (2) und der Blende (3) angeordnet ist.

14. Vorrichtung nach einem der vorherigen Ansprüche, wobei
- das strahlungsemittierende Bauelement (1) ein strahlungsemittierendes Halbleiterbauelement und/oder eine Fluoreszenzlampe umfasst.

## Claims

1. Radiation-emitting apparatus for emitting a variable electromagnetic secondary radiation (6) in an emission direction (10), comprising
- at least one radiation-emitting component (1) which emits during operation an electromagnetic primary radiation (4),
- a reflector (2), which is arranged in the beam path of the radiation-emitting component (1) and has a first wavelength conversion substance (21) for the at least partial conversion of the primary radiation (4) into electromagnetic conversion radiation (5), **characterised by**
- an aperture (3), which is variable in terms of its orientation relative to the radiation-emitting component (1) and to the reflector (2),
wherein
- by way of changing the orientation of the aperture (3) the secondary radiation (6) is variable by changing that proportion (41) of the primary radiation (4) which is emitted by the radiation-emitting component (1) onto the first wavelength conversion substance (2), and by changing the emitted conversion radiation (5).

2. Apparatus according to claim 1, wherein
- the reflector (2) comprises a first sub-area with the first wavelength conversion substance (21) and a second sub-area with a second wavelength conversion substance (22), different from different from the first wavelength conversion substance (21), for the conversion of the primary radiation (4) into electromagnetic conversion radiation (5) and
- by changing the orientation of the aperture (3), the proportion emitted by the first sub-area and the proportion emitted by the second sub-area of the conversion radiation (5) in the secondary radiation (6) are variable relative to each other.

3. Apparatus according to the preceding claim, wherein
- the reflector (2) comprises a plurality of first and second sub-areas arranged alternately side by side.

4. Apparatus according to one of the preceding claims, wherein
- the reflector (2) is partially reflecting for the primary radiation (4).

5. Apparatus according to one of the preceding claims, wherein
- the aperture (3) is at least partially reflecting.

6. Apparatus according to one of the preceding claims, wherein
- the aperture (3) comprises a third wavelength conversion substance (31) and
- by changing the orientation of the aperture (3), the proportion of the primary radiation (4), which is emitted by the radiation-emitting component (1) onto the third wavelength conversion substance (31), is variable.

7. Apparatus according to one of the preceding claims, wherein
- the aperture (3) comprises at least one opening (30).

8. Apparatus according to the preceding claim, wherein
- at least one part of the conversion radiation (5) is emitted through the opening (30) by the radiation-emitting apparatus.

9. Apparatus according to claim 7 or 8, wherein
- the aperture (3) comprises a plurality of openings (30).

10. Apparatus according to one of the preceding claims, wherein
- the orientation of the aperture (3) relative to the radiation-emitting component (1) is variable by a translation (90) and/or a rotation (91).

11. Apparatus according to one of the preceding claims, wherein
- the aperture (3), viewed by an external observer covers at least a part of the reflector (2), which is variable by changing the arrangement of the aperture (3).

12. Apparatus according to one of claims 1 to 11, wherein
- the aperture (3) is arranged between the radiation-emitting component (1) and the reflector (2).

13. Apparatus according to one of claims 1 to 11, wherein
- the radiation-emitting component (1) is arranged between the reflector (2) and the aperture (3).

14. Apparatus according to one of the preceding claims, wherein
- the radiation-emitting component (1) comprises a radiation-emitting semiconductor component and/or a fluorescent lamp.

## Revendications

1. Dispositif émetteur de rayonnement destiné à émettre un rayonnement secondaire (6) électromagnétique modifiable dans une direction d'émission (10), comprenant
- au moins un composant émetteur de rayonnement (1), émettant en fonctionnement un rayonnement primaire (4) électromagnétique,
- un réflecteur (2), disposé dans la trajectoire des rayons du composant émetteur de rayonnement (1) et comportant une première matière de conversion de longueur d'onde (21) pour convertir au moins partiellement le rayonnement primaire (4) en un rayonnement de conversion (5) électromagnétique, **caractérisé en ce que**
- un écran (3) est prévu, dont l'orientation par rapport au composant émetteur de rayonnement (1) et au réflecteur (2) est modifiable,
dans lequel
- au moyen d'une modification de l'orientation de l'écran (3), le rayonnement secondaire (6) est modifiable par modification de la part (41) du rayonnement primaire (4) émise par le composant émetteur de rayonnement (1) sur la première matière de conversion de longueur d'onde (2), et par modification du rayonnement de conversion (5) émise.

2. Dispositif selon la revendication 1, dans lequel
- le réflecteur (2) présente une première zone partielle comportant la première matière de conversion de longueur d'onde (21), et une deuxième zone partielle comportant une deuxième matière de conversion de longueur d'onde (22), différente de la première matière de conversion de longueur d'onde (21), pour convertir le rayonnement primaire (4) en rayonnement de conversion (5) électromagnétique, et
- par modification de l'orientation de l'écran (3), la part émise par la première zone partielle et la part émise par la deuxième zone partielle du rayonnement de conversion (5) dans le rayonnement secondaire (6) sont modifiables l'une par rapport à l'autre.

3. Dispositif selon la revendication précédente, dans lequel
- le réflecteur (2) présente une pluralité de premières et deuxièmes zones partielles, disposées côte à côte en alternance.

4. Dispositif selon l'une des revendications précédentes, dans lequel
- le réflecteur (2) est partiellement réfléchissant pour le rayonnement primaire (4).

5. Dispositif selon l'une des revendications précédentes, dans lequel
- l'écran (3) est d'une configuration au moins partiellement réfléchissante.

6. Dispositif selon l'une des revendications précédentes, dans lequel
- l'écran (3) comporte une troisième matière de conversion de longueur d'onde (31), et
- par modification de l'orientation de l'écran (3), la part du rayonnement primaire (4) émise par le composant émetteur de rayonnement (1) sur la troisième matière de conversion de longueur d'onde (31) est modifiable.

7. Dispositif selon l'une des revendications précédentes, dans lequel
- l'écran (3) comporte au moins une ouverture (30).

8. Dispositif selon la revendication précédente, dans lequel
- au moins une partie du rayonnement de conversion (5) est émise par le dispositif émetteur de rayonnent à travers l'ouverture (30).

9. Dispositif selon la revendication 7 ou 8, dans lequel
- l'écran (3) comporte une pluralité d'ouvertures (30).

10. Dispositif selon l'une des revendications précédentes, dans lequel
- l'orientation de l'écran (3) par rapport au composant émetteur de rayonnement (1) est modifiable par une translation (90) et/ou une rotation (91).

11. Dispositif selon l'une des revendications précédentes, dans lequel
- l'écran (3), vu d'un observateur externe, recouvre au moins une partie du réflecteur (2), laquelle est modifiable par des modifications de la disposition de l'écran (3).

12. Dispositif selon l'une des revendications 1 à 11, dans lequel
- l'écran (3) est disposé entre le composant émetteur de rayonnement (1) et le réflecteur (2).

13. Dispositif selon l'une des revendications 1 à 11, dans lequel
- le composant émetteur de rayonnement (1) est disposé entre le réflecteur (2) et l'écran (3).

14. Dispositif selon l'une des revendications précédentes, dans lequel
- le composant émetteur de rayonnement (1) comprend un composant semi-conducteur émetteur de rayonnement et/ou une lampe fluorescente.
